(19) Europäisches Patentamt
European Patent Office
Office européen des brevets

(11) Publication number : **0 505 094 A1**

# (12) EUROPEAN PATENT APPLICATION

(21) Application number : **92302146.3**

(51) Int. Cl.$^5$ : **G03F 7/004,** G03F 7/022

(22) Date of filing : **12.03.92**

(30) Priority : **19.03.91 GB 9105750**

(43) Date of publication of application : **23.09.92 Bulletin 92/39**

(84) Designated Contracting States : **DE FR GB IT**

(71) Applicant : **MINNESOTA MINING AND MANUFACTURING COMPANY**
**3M Center, P.O. Box 33427**
**St. Paul, Minnesota 55133-3427 (US)**

(72) Inventor : **Newman, Stephen**
**33 Manston Drive**
**Bishops Stortford,Herts. CM23 5EJ (GB)**
Inventor : **Hauri, Robert J., c/o 3M Centre**
**Building 235-1B-24**
**St. Paul, Minnesota 55144 (US)**

(74) Representative : **Bowman, Paul Alan et al**
**LLOYD WISE, TREGEAR & CO. Norman House**
**105-109 Strand**
**London WC2R OAE (GB)**

## (54) Speed stabilised positive-acting photoresist compositions.

(57) A positive-acting photoresist comprising in one or more layers
(i) a resin binder,
(ii) a photo-acid generator, and
(iii) an acid-cleavable compound,
characterised in that the photoresist medium further comprises as a speed stabilising agent one or more compounds having a nucleus of general formula (I) :

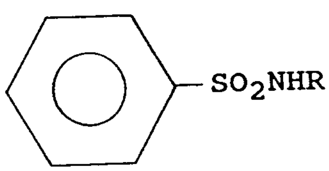

I

in which ;

R represents a hydrogen atom or an optionally substituted alkyl group comprising up to 10 carbon atoms.

EP 0 505 094 A1

This invention relates to positive-acting photoresists and in particular to positive-acting photoresists having a photosensitive media comprising a resin binder, photo-acid generator, an acid cleavable compound and as a speed stabilising agent one or more arylsulphonamide derivatives of defined structure.

Positive-acting photoresists find widespread use in fields such as lithographic printing, proofing and microlithography and are characterised by their ability to become more soluble in an appropriate developer when irradiated with light of a suitable wavelength. The vast majority of positive resists available on the market comprise an alkali-soluble resin, normally a phenol-formaldehyde resin, and a light-sensitive solubility inhibitor. Photolysis of the latter results in an increase in solubility. Most commonly, the solubility inhibitor is a diazonaphthoquinone derivative (also known as a quinone diazide, or a diazo-oxide). U.S. Patent No. 4,708,925 discloses the use of onium salts as solubility inhibitors. In recent years, there has been considerable emphasis on increasing the photosensitivity of positive resists by providing chemical amplification of the initial photochemical process.

This is most often achieved by formulating a suitable binder, typically, a phenolic resin, with a photo-acid generator and an acid-cleavable compound. Examples of such systems are disclosed in U.S. Patent Specification Nos. 3,779,778, 4,247,611, 4,248,957, 4,250,247, 4,311,782, European Patent Publication Nos. 202196 and 249139, German Patent No. 3601264 and Japanese Patent Application No. 62-059949. The acid cleavable compound is a compound which converts catalytically in the presence of acid from an insoluble (or insolubilising) form to a soluble (or non-insolubilising) form. The mechanism may involve, for example, cleavage of a polymer to low molecular weight fragments, or conversion of non-polar groups into polar derivatives, but the end result is that the initial photochemical event (photogeneration of acid) is amplified into the cleavage of large numbers of bonds.

A problem that has arisen with compositions of the above type is that of shelf-stability. Although high imaging speeds are obtained for freshly-coated materials, storage over a period of weeks can result in serious losses in speed. The problem also manifests itself as a variation in speed with the time interval between exposure and development. Thus, an aged coating developed immediately after exposure will exhibit a slower speed than one whose development is delayed for some time, e.g., one hour. Another manifestation of the problem is variation of the "soak time", that is, the time taken by the exposed coating to dissolve completely in the developer. Ideally, this should be constant, but has been found to increase as the coating ages, and to vary with the time interval between exposure and development. Although all these effects may be eliminated to a large extent by briefly heating the coating, either immediately before or immediately after the exposure, obviously it is preferable that the coatings should exhibit a stable photoresponse over a period of months or years without recourse to special treatments or techniques.

European Patent Publication No. 290916 discloses one solution to the problem in the form of a barrier layer of poly(vinyl alcohol) or similar materials coated on top of the photosensitive layer of the photoresist. The present invention provides an alternative solution by the addition of aryl sulphonamides of defined formula to the photosensitive layer, thereby obviating the need for two coating trips.

French Patent Specification No. 2325076 discloses a range of compounds as additives to a conventional positive resist formulation comprising a phenol-formaldehyde resin and a diazonaphthoquinone. The compounds are said to provide an improved photo-speed and contrast. Sulphonamides are included in the range of compounds. There is no mention of positive resists of the chemically amplified type, comprising a photo-acid generator and acid-cleavable compound.

The present invention seeks to provide speed-stabilised positive-acting photoresist compositions, particularly for use in the manufacture of printing plates, having a more stable response over a given period when compared with conventional amplified photo-resist systems.

According to the present invention there is provided a positive-acting photoresist comprising in one or more layers:

(i) a resin binder,

(ii) a photo-acid generator, and

(iii) an acid-cleavable compound,

characterised in that the photoresist medium further comprises as a speed stabilising agent one or more compounds having a nucleus of general formula (I):

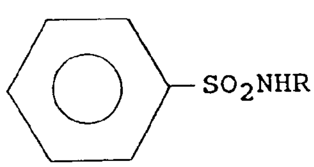

I

in which;

R represents a hydrogen atom or an alkyl group comprising up to 10 carbon atoms, preferably up to 6 carbon atoms, which may optionally possess one or more substituents selected from hydroxy, nitro, halogen atoms, alkoxy groups comprising up to 5 carbon atoms and ester groups comprising up to 5 carbon atoms. R preferably represents a hydrogen atom or an alkyl moiety selected from methyl, ethyl, propyl and butyl.

In addition to the speed stabilising agent of Formula I, the positive-acting photoresists of the invention comprise:

a resin binder, which is readily soluble in a developer solution, e.g., aqueous alkali;

an acid-cleavable compound having the property of retarding/suppressing the dissolution of the resin binder and

a photo-acid generator which upon exposure to light of the appropriate wavelength and intensity, releases acid to convert/destroy the acid-labile compound, thereby restoring the original solubility of the resin. This process is referred to as photosolubilisation.

Photoresist coatings manufactured in accordance with the present invention have a good sensitivity and a stable response following storage at ambient temperature for several months or more. Corresponding coatings without the sulphonamide show losses in speed after as little as three weeks storage. In a preferred embodiment the photoresists show particular utility in printing plates.

The speed stabilising agents of general formula (I) may optionally possess one or more substituents on the phenyl ring. Preferably, such substituents are of relatively low molecular weight and neutral polarity. These compounds must not significantly affect the photosolubilisation chemistry such that amino and other strongly basic groups that would scavenge the acid are unsuitable substituents. Furthermore, the compounds of formula (I) desirably have a minimal effect on the overall solubility of the photoresist medium in the developer solution, typically an alkali solution, so that both strongly hydrophobic and strongly hydrophilic groups are generally unsuitable substituents. Examples of the former include long chain alkyl groups ($C > 10$) and highly fluorinated groups, and examples of the latter include: $-CO_2H$, $-SO_3H$, and phenol ($-C_6H_4OH$) moieties. Suitable ring substituents include halogen atoms, alkyl groups comprising up to 10 carbon atoms, preferably up to 5 carbon atoms and nitro groups.

Examples of compounds of general formula (I) suitable for use as speed stabilising agents in the photoresists of the present invention include benzene sulphonamide, N-ethyl-p-toluene sulphonamide, N-ethyl-o-toluene sulphonamide, N-butyl-p-toluene sulphonamide, o-toluene sulphonamide and p-toluene sulphonamide. A mixture of such compounds is also permissable. A preferred speed stabilising agent comprises a mixture of 45 weight % N-butyl-p-toluene sulphonamide, 45 weight % of N-ethyl-p-toluene sulphonamide, 5 weight % of o-toluene sulphonamide and 5 weight % of p-toluene sulphonamide, commercially available from Akzo Chemie under the trade name Ketjenflex 8. Another useful mixture comprises 50 weight % of N-ethyl-p-toluene sulphonamide and 50 weight % of N-ethyl-o-toluene sulphonamide.

Generally, the compounds of formula (I) comprise up to 25% by weight, preferably 5 to 20% by weight and more preferably 10 to 15% by weight of the total solids content of the photosensitive medium.

The resin may be chosen from a wide range of soluble resins known in the art but resins capable of forming tack-free coatings which are soluble in alkali developer are preferred, including both resoles and novolacs. Such resins typically comprise an alkali-soluble binder having a plurality of phenol groups, e.g., phenol formaldehydes etc. The novolac and resole resins, as is known in the art, are produced by condensing the phenol with an aldehyde in the presence, respectively of an acid or basic catalyst. Although resins obtained from condensation with formaldehyde are generally employed, resins derived from other aldehydes such as, for example, acetaldehyde, chloral, butyraldehyde, furfural and the like, may also be used. Mixtures of two or more types of resin may also be used, including those resins possessing additional alkyl substituents on the aromatic ring. The preferred phenolic resin is m-cresol novolac resin. Other suitable resins include hydroxy-styrene copolymers and derivatives thereof.

As a vast number of known compounds and mixtures, such as diazonium salts, phosphonium salts, sulphonium salts, e.g., triphenyl sulphonium salts and iodonium salts or halogen compounds, quinone diazide sulfochlorides, trichloromethylpyrones, bis(trichloromethyl)-s-triazines, e.g., 2-(p-methoxystyryl-4,6-bis(trichloromethyl)-s-triazine, and organometal/organohalogen combinations may be used as radiation-sensitive constituents forming or splitting-off acids during irradiation.

Suitable diazonium salts are compounds having an absorption range between 300 and 600 nm, which are known to be suitable for diazotype purposes. Compounds containing no basic substituents are preferred.

As a rule, the above mentioned diazonium, phosphonium, sulfonium and iodonium compounds are used in the form of salts soluble in organic solvents, normally as the separation products with complex acids, such as tetrafluoroboric acid, hexafluorophosphoric acid, hexafluoroantimonic acid and hexafluoroarsenic acid.

Alternatively, derivatives of positive working o-quinone diazides may be used. In most cases, the acidity

of the indene carboxylic acids produced by exposing the o-naphthoquinone diazides is barely sufficient for a satisfactory imagewise differentiation but from this group of compounds, naphthoquinone-1,2-diazide-4-sulfochloride is preferred, because, during its exposure, three acid functions are formed which give rise to a relatively high degree of intensification during cleavage of the acid-labile compound.

In principle, all organic halogen compounds known as free radical forming photoinitiators, for example, those containing more than one halogen atom attached to a carbon atom or an aromatic ring, may be used as halogen containing radiation-sensitive compounds capable of forming a hydrohalic acid. Examples of such compounds are disclosed in U.S. Patent Nos. 3,515,552, 3,536,489 and 3,779,778 and in German Offenlegungsschrift No. 2243621. The effect of these halogen containing compounds in the photoresists of the invention may be spectrally influenced and increased by the addition of known sensitisers.

Furthermore, certain substituted trichloromethylpyrones, such as those described in German Offenlegungsschrift No. 2610842 may also be used, as well as 2-aryl-4,6-bis-trichloromethyl-s-triazines.

Examples of suitable photo-acid generators are:

4-(di-n-propyl-amino)-benzene-diazonium-tetrafluoroborate,
4-p-tolylmercapto-2,5-diethoxy-benzene-diazonium hexafluorophosphate,
4-p-tolymercapto-2,5-diethoxy-benzene-diazonium tetrafluoroborate.
diphenylamine-4-diazonium sulfate,
4-methyl-6-trichloromethyl-2-pyrone,
4-(3,4,5-trimethoxy-styryl)-6-trichloromethyl-2-pyrone,
4-(4-methoxy-styryl)-6-(3,3,3-trichloro-propenyl)-2-pyrone,
2-trichloromethyl-benzimidazole,
2-tribromomethyl-quinoline,
2,4-dimethyl-1-tribromoacetyl-benzene,
3-nitro-1-tribromo-acetyl-benzene,
4-dibromoacetyl-benzoic acid,
1,4-bis-dibromomethyl-benzene,
tris-dibromomethyl-s-triazine,
2-(6-methoxy-naphth-2-yl)-4,6-bis-trichloromethyl-s-triazine,
2-(naphth-1-yl)-4,6-bis-trichloromethyl-s-triazine,
2-(naphth-2-yl)-4,6-bis-trichloromethyl-s-triazine,
2-(4-ethoxyethyl-naphth-1-yl)-4,6-bis-trichloromethyl-s-triazine,
2-(benzopyran-3-yl)-4,6-bis-trichloromethyl-s-triazine,
2-(4-methoxy-anthracene-1-yl)-4,6-bis-trichloromethyl-s-triazine, and
2-(phenanthr-9-yl)-4,6-bis-trichloromethyl-s-triazine.

The quantity of the photo-acid generator may vary widely depending on its chemical nature and the exact composition of the photosensitive medium and is generally in the range from 0.1 to 20% by weight, based on the total weight of the solids. Good results are obtained with quantities ranging from about 0.1 to about 10% by weight, based on the total weight of the solids, with quantities in the range from 2 to 10% by weight being preferred.

The preferred photo-acid generators for use in the present invention are iodonium salts having a nucleus of general formula (II):

(II)

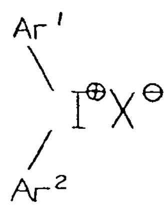

in which;

$Ar^1$ and $Ar^2$ independently represent aromatic or hetero-aromatic groups comprising up to 10 ring atoms which may be linked together to include the iodine atom within a ring structure, and

$X^{\ominus}$ is an anion such that HX is an acid of $k_a$ greater than 3.

In the iodonium compound $Ar^1$ and $Ar^2$ are aromatic groups generally comprising from 4 to 10 carbon atoms, and may be selected from aromatic hydrocarbon rings, e.g., phenyl or naphthyl, and hetero-aromatic groups including thienyl, furanyl and pyrazolyl, which may be substituted with alkyl groups comprising up to 5 carbon

atoms, e.g., methyl, alkoxy groups comprising up to 4 carbon atoms, e.g., methoxy, halogen atoms, e.g., chlorine, bromine, iodine and fluorine, carboxy, cyano or nitro groups, or any combinations thereof. Condensed aromatic-heteroaromatic groups, e.g., 3-indolinyl, may also be present.

Preferably $Ar^1$ and $Ar^2$ do not have more than two substituents at the $\alpha$ positions of the aryl groups. Most preferably $Ar^1$ and $Ar^2$ are both phenyl groups containing no a substituents.

Preferred groups for $Ar^1$ and $Ar^2$ include:

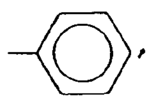, 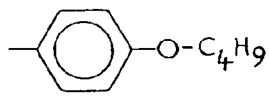 and 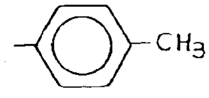

The $\alpha$ positions of the aryl groups may be linked together to include the iodine atom within a ring structure to give a formula such as:

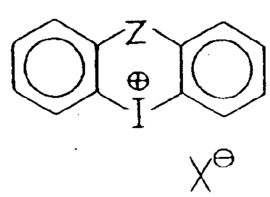

in which Z is an oxygen or sulphur atom and X is as defined above.

Many anions are useful as the counter-ion in the onium salt, provided the acid from which the anion is derived has a pKa of less than 3, preferably less than 1. Suitable inorganic anions include halide anions, $HSO_4^{\ominus}$, and halogen-containing complex anions, e.g., tetrafluoroborate, hexafluorophosphate, hexafluoroarsenate and hexafluoroantimonate. Suitable organic anions include, for example:

$CF_3CO_2^{\ominus}$, $CCl_3CO_2^{\ominus}$, $CH_3SO_3^{\ominus}$, $CF_3SO_3^{\ominus}$, $CH_3C_6H_4SO_3^{\ominus}$

The iodonium salt generally comprises from 0.5 to 20%, preferably 1 to 10% and, most preferably 2 to 5% by weight of the photoresist medium.

A wide variety of acid-cleavable compounds may be used in the present invention. Such compounds generally comprise an acid cleavable C-O-C or C-O-Si linkage in their structure. Examples of such compounds include: adducts of vinyl ethers with phenols or sulphonamides (disclosed in U.S. Patent No. 3,779,778), polyacetals and polyketals (disclosed in U.S. Patent No. 4,247,611), enol ethers (disclosed in U.S. Patent No. 4,248,957), N-acyliminocarbonates (as disclosed in U.S. Patent No. 4,250,247), polymeric ortho-esters (as disclosed in U.S. Patent No. 4,311,782), t-alkyl esters and carbonates (as disclosed in European Published Patent Application No. 249139), cyclic acetals and ketals of $\beta$-ketocarbonyl compounds (as disclosed in European Published Patent Application No. 202196) and various silyl compounds including silyl ether and silyl ureido compounds (as disclosed in German Patent No. 3601264 and Japanese Patent Application No. 62-059949).

However, preferred acid cleavable compounds comprise tetrahydro-pyranyl and -furanyl ethers of a bisphenol as disclosed in our co-pending European Patent Application No. 90311399.1 filed 17th October, 1990. Such compounds have a nucleus of general formula (III):

(III) 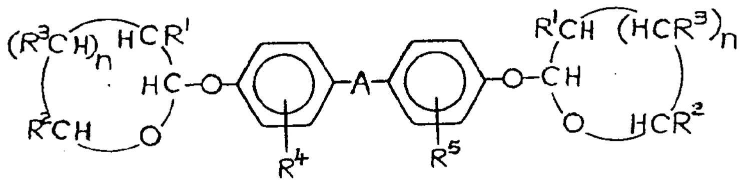

in which;

n is 0, 1, 2 or 3,

each $R^1$, $R^2$ and $R^3$ independently represents hydrogen or an alkyl group comprising up to 4 carbon atoms,

$R^4$ and $R^5$ independently represent hydrogen or one or more ring substituents selected from C1, Br, F,

alkyl groups comprising up to 4 carbon atoms, alkoxy groups comprising up to 4 carbon atoms and combinations thereof, and

A represents a bond or a divalent linking group containing up to 10 atoms other than hydrogen. Compounds of general formula (III) are particularly useful when the photo-acid generator is an iodonium salt.

In the compound of Formula (III), n is preferably 1 or 2 and each of $R^1$ to $R^5$ is hydrogen. A may represent a wide range of divalent groups including cyclic and linear groups generally composed of atoms selected from C, N,S,O and H. Preferred groups include:

$-CH_2-$, $-SO_2-$, 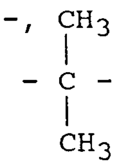

and other hydrocarbon bridge groups, preferably of up to 8 carbon atoms.

The compound(s) of Formula (III) generally comprises from 5 to 30%, preferably from 7.5 to 20% and most preferably from 10 to 15% by weight of the photoresist medium.

Examples of suitable acid cleavable compounds represented by Formula (III) include:

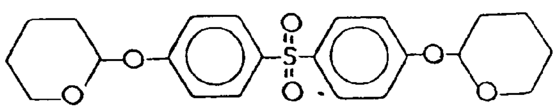

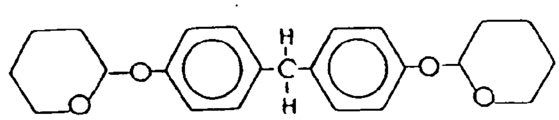

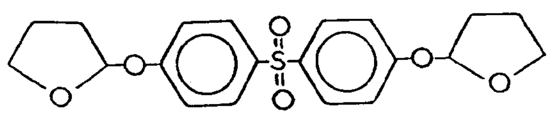

The photoresists of the invention are preferably sensitive to light in the visible or near U.V. regions. Some photo-acid generators, such as diazonium salts, diazo-oxides and certain triazine and pyrone derivatives are intrinsically sensitive to these wavelengths, but others, notably iodonium salts and sulphonium salts, benefit from the addition of a sensitiser for the photo-acid generator in order to increase the sensitivity of the system towards radiation of a wavelength longer than that of the intrinsic sensitivity of the photo-acid generator itself. Many such compounds are known including those in the following classes: diphenylmethane including substituted diphenylmethane, such as amino substituted diphenylmethane, xanthene, acridine, methine and polymethine (including oxonol, cyanine and merocyanine), thiazole, thiazine, azine, aminoketone, porphyrin, aromatic polycyclic hydrocarbon, p-substituted aminostyryl compound, aminotriazylmethane, polyarylene, polyarylpolyene, 2,5-diphenylisobenzofuran, 2-5-diarylcyclopentadiene, diarylfuran, diarylthiofuran, diarylpyrrole, polyarylphenylene, coumarin and polyaryl-2-pyrazoline. The addition of a sensitiser to the system renders it sensitive to any radiation falling within the absorption spectrum of the sensitiser. The efficiency of the irradiation will increase the nearer it coincides with $\lambda$ max of the sensitiser.

However, preferred sensitisers for use with the present invention do not scavenge the photo-generated acid necessary for the solubilising process and so dyes possessing easily protonated groups are unlikely to be suitable. A preferred class of sensitisers for use with iodonium and sulphonium salts includes polycyclic aromatic hydrocarbons and their derivatives, e.g., anthracene, 2-ethylanthracene, 9,10-diethoxyanthracene, 2-ethyl-9,10-diethoxyanthracene etc.

The sensitiser is preferably present in an amount that makes maximum use of the incident light. This will vary according to the layer thickness, the extinction coefficient of the dye, and the extent to which its absorption spectrum matches the output of the exposing source, as is well understood by those skilled in the art. Generally the sensitiser will be present in amounts up to 15% by weight of the total solids composition. Where the output of the exposing source does not match the maximum absorption of the dye an amount in excess of this may be employed.

In most applications, the sensitiser is chosen so as to match as closely as possible the output of the intended exposure device, but in one embodiment, the sensitiser is chosen so that sensitivity is confined to the near UV region, with essentially no response to light of wavelengths greater than 400nm. This provides a photoresist that is handleable under white-light conditions, rather than requiring the yellow lighting normally used in the press-room, but can be imaged by conventional exposing devices with a realistic exposure time. Many commercially available exposing devices for printing plates and other photoresist materials emit predominantly in the blue region (above 400nm), with a relatively weak UV component, but such is the sensitivity shown by preferred formulations in accordance with the present invention that inefficient exposures of this sort can be tolerated without unduly lengthening the exposure time. Sensitisers suitable for this application include anthracene and its 2-ethyl derivative.

The photoresist composition may additionally contain small amounts of other ingredients commonly incorporated in photoresist formulations, e.g., dyes or pigments that enhance the visibility of the post-exposure or post-development image, surfactants to improve the coatability, and oils or resins to improve the ink receptivity when used as a printing plate.

The photoresist composition may be coated on a hydrophilic substrate for use as a lithographic printing plate. A wide variety of coating solvents may be used, including lower alcohols, ketones, ethers and esters. Particularly suitable solvents are methyl ethyl ketone and methyl isobutyl ketone. Mixtures of solvents may also be used. Any of the well known coating techniques may be used, e.g., coating with wire-wound bars, spin-coating, knife-coating, dip-coating, roller-coating, etc.

Typical lithographic support materials which are useful in the invention include supports such as zinc, anodized aluminium, grained aluminium, copper and specially prepared metal and paper supports; superficially hydrolysed cellulose ester films; polymeric supports such as polyolefins, polyesters, polyamide and the like.

The supports can be sub-coated with known subbing materials such as copolymers and terpolymers of vinylidene chloride with acrylic monomers (such as acrylonitrile ant methyl acrylate) and unsaturated dicarboxylic acids (such as itaconic acid or acrylic acid); carboxymethyl cellulose, polyacrylamide; and similar polymeric materials.

The support can also carry a filter or antihalation layer, such as one comprising a dyed polymer layer which absorbs the exposing radiation after it passes through the radiation-sensitive layer and eliminates unwanted reflection from the support. A yellow dye in a polymeric binder, such as one of the polymers referred to above as suitable sub-coatings, is an especially effective antihalation layer when ultraviolet radiation is employed as the exposing radiation.

In the manufacture of a printing plate, after coating, the composition is dried briefly at an elevated temperature, e.g., 3 minutes at 85°C.

After exposure, the plate is developed in aqueous alkaline developer and the exposed areas of the coating removed. A wide range of alkaline solutions may be used to develop the plate, e.g., sodium hydroxide or trisodium phosphate solution, but the preferred developer is aqueous sodium metasilicate in the concentration range of 2 to 10 weight %, optionally containing small amounts of surfactants and/or organic solvents. After development, the plate is mounted on press and used to print copies in the normal manner.

The photoresist compositions may also be used as positive photoresists for the preparation of metal-clad printed circuit boards, e.g., copper sheet laminated to an epoxy resin board. In this instance, the copper would be coated with the photosensitive composition. After exposure the solubilised material would be removed leaving an integral mask. Unprotected areas of copper would then be removed by etching such as with aqueous ferric chloride solution.

The photoresist compositions may also be used to protect other materials such as amorphous $SiO_2$. Silica is often used in the fabrication of electronic devices and integrated circuitry and the contact patterns for these devices are often defined through photomasks.

The photoresist compositions may also be used in other applications, e.g., proofing constructions in which the compositions contain a high loading of a colour-proofing pigment.

The photoresists of the invention exhibit an improved and most importantly consistent speed on prolonged storage, which speed is often superior to that of similar coatings lacking a compound of general formula (I).

The invention will now be illustrated by the following Examples in which the acid-cleavable compound was:

Compound I

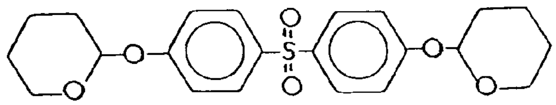

and, the iodonium salt

Iodonium Salt I

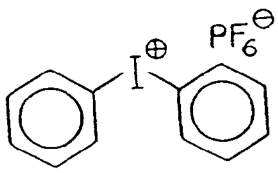

Preparation of Compound I

A mixture of dihydropyran (85g), p-toluenesulphonic acid (0.1g) and concentrated hydrochloric acid (2 drops) was stirred vigorously with ice-bath cooling as 4,4-sulphonyldiphenol (31.3g) was added in small portions. The resulting thick slurry was stirred for 3 hours at room temperature, diluted with ethyl acetate (300ml), and filtered to remove a small amount of insoluble material. The filtrate was extracted with 2N NaOH (3 x 50ml extractions) and water (a further 3 x 50ml extractions), before drying over $MgSO_4$. The solvent was removed under reduced pressure until a solid began to separate, whereupon a large volume of ether was added and the mixture stored in the refrigerator until no more solid precipitated. The product was collected, washed with ether and dried in a vacuum oven. Yield 21.4g; melting point = 163 - 164°C.

Coating Procedures

All coatings were made with m-cresol novolak resin, (commercially available from Borden Chemicals) as binder, using a 20% w/w solution in 2-butanone unless otherwise stated. Coatings were made on grained, anodised aluminium base (commercially available from Cookson Graphics Inc, under the trade designation 1-A-1) using a wire-wound bar to give a wet coating thickness of 12 μm, and dried at 85°C for 3 minutes.

Development

This was carried out in sodium metasilicate solutions of a given strength (e.g., 6% w/v) in a temperature controlled bath (22°C). The standard routine was a 1 minute immersion with intermittent rubbing with a lambswool pad, followed by rinsing in tap water.

Coating Weight Loss (CWL)

This was measured as the percentage (by weight) of coating that was lost when an unexposed sample was subjected to the standard development routine.

Speed

Unless otherwise indicated, exposures were carried out using a Nu-Arc model 40-6K contact frame, fitted with a 6kW metal halide lamp ("KT Ultra-plus instant start") at a distance of 102 centimeters from the easel. Under these conditions, one unit of exposure corresponds to an energy density of $2.8 \times 10^5$ ergs/cm$^2$ integrated over the entire output wavelength range, or an exposure time of approximately 1.5 seconds. The bulk of the output of this lamp is above 400nm.

Samples were exposed through a step wedge to a given number of units, developed as described above and then inked by hand. This procedure comprises wiping the image with phosphoric acid (1% solution) and then printing ink, the latter adhering preferentially to the undissolved resin image. The optical density (of the wedge) at which photosolubilisation ceased was thus revealed and by converting it to percentage transmission,

it was possible to calculate the minimum exposure required to achieve photosolubilisation at 100% transmission, assuming no reciprocity failure.

Example 1

The following coating formulations were coated onto grained and anodised aluminium base at 12μm wet thickness and dried for 3 minutes at 85°C.

Control Formulation 1

| | |
|---|---|
| m-cresol novolak resin | 2.5g |
| Iodonium salt I | 0.05g |
| 9,10-diethoxyanthracene | 0.05g |
| Compound I | 0.1g |

Coating Formulation A

As per the Control Formulation plus N-ethyl-p-toluene sulphonamide (0.10g).

The coatings were stored in the dark at 40°C, and samples tested for speed at various intervals over a period of 49 days. This involved exposing samples through a step wedge to a 6kW metal halide source at a distance of 102cm. Following development in 9% w/v sodium metasilicate solution, the images were inked by hand, and the optical density at which photosolubilisation ceased was noted. By converting this to % transmission, it was possible to calculate the minimum exposure required to achieve photosolubilisation. The results for each coating are shown in Table 1 below.

Table 1

| Coating | Age (days) | Speed* |
|---|---|---|
| Control Formulation 1 | 6 | 1.7 |
| | 23 | 2.0 |
| | 34 | 7.5 |
| | 49 | 8.0 |
| Coating Formulation A | 1 | 0.6 |
| | 36 | 1.0 |
| | 49 | 0.6 |

* units required to achieve photosolubilisation.

Thus, the control coating having no speed stabilising agent suffered a 4 to 5 fold loss of speed, whereas coating A in accordance with the invention remained essentially stable.

Example 2

m-Cresol novolac resin (commercially available from Borden Chemicals under the trade designation LP6-GO9) Irgalite Blue GLV, copper phthalocyanine pigment commercially available from Ciba-Geigy, and methyl isobutyl ketone (MIBK) were milled together to produce a 31.3% by weight solids dispersion with a resin: pigment ratio of 18.8 : 1 by weight. This dispersion was formulated with other ingredients as follows (all parts by weight) :

| | |
|---|---|
| Dispersion | 13.95 parts |
| Iodonium Salt I | 0.266 parts |
| Compound I | 0.804 parts |
| 2-ethyl-9,10-dimethoxyanthracene | 0.670 parts |
| Ketjenflex-8 | 0.774 parts |
| MIBK | 11.53 parts |

to give a 24.6% by weight solids coating solution. This solution was then coated on Advance 1-A-1 aluminium base and dried at 88°C to give a dry coating weight of 2.05g/m$^2$ (Coating B).

The dried coating was stored in the dark at ambient temperature and samples evaluated at intervals by exposure on a Berkey-Ascor printing frame followed by subsequent development for 2 minutes in a 5.6% w/v sodium metasilicate solution at a fixed temperature. The speed of each sample was determined as described in Example 1 and the soak time also recorded. The % coating weight loss (CWL) of unexposed samples subjected to the same development routine was also measured. The results are presented in Table 2 below.

Table 2

| Age (Days) | Speed (a) | Soak Time (secs.) | % CWL (b) |
|---|---|---|---|
| 5 | 3.5 | 15 | 4.5 |
| 7 | 3.8 | 20 | 4.2 |
| 12 | 3.2 | 18 | 4.0 |
| 18 | 3.5 | 19 | 6.3 |
| 27 | 4.5 | 16 | 4.7 |
| 50 | 3.5 | 23 | 5.0 |

(a) Minimum number of units to achieve photosolubilisation.

(b) Coating weight loss from unexposed areas.

The above results show that the important parameters of speed, soak time and CWL remained reasonably constant over the test period of 50 days.

Example 3

Control Formulation 2 and Coating Formulation C were prepared in the same manner as Coating Formulation B of Example 2, except that in Coating Formulation C the Ketjenflex-8 was replaced by an equal weight of N-ethyltoluene-sulphonamide (1 : 1 mixture of ortho and para isomers), while Control Formulation 2 contained no stabilising additive. Both coatings were dried at 80°C. After aging 42 days in the dark at ambient temperature, samples of both coatings were given equal exposures on a Berkey-Ascor unit before immersion in a 5.6% w/v sodium metasilicate at a fixed temperature with varying time intervals between the end of exposure and start of development. The time for the exposed areas to dissolve fully (the soak time) was noted, and the results presented in Table 3 below.

Table 3

| | Soak Time (secs.) | |
|---|---|---|
| Time Interval (secs.) | Coating Formulation C | Control Formulation 2 |
| 10 | 24 | 48 |
| 120 | 15 | 35 |
| 540 | 15 | 26 |

Thus, the Control Formulation gave a significantly longer soak time, which varied considerably with the time interval between exposure and development when compared with Coating Formulation C of the invention.

"Ketjenflex 8", "Berkey-Ascor", "Nu-arc" and "KT Ultra-plus" are all trade names.

Example 4

This Example tests the effect of a sulphonamide compound of the invention on a positive resist that does not contain an acid-cleavable compound.

Control Formulations 3 and 4 were prepared as for Control Formulation 1 described in Example 1, except that Compound 1 was omitted and Control Formulation 4 additionally contained 0.075g N-ethyl p-toluenesulphonamide. Each formulation was coated on aluminium base as described in Example 1, stored in the dark at 40°C, then tested for speed as described in Example 1, except that Control Formulation 3 was developed in 7% w/v sodium metasilicate and Control Formulation 4 in 4% w/v sodium metasilcate. This arrangement enabled both coatings to show comparable developer resistance (prior to exposure), which is necessary for meaningful speed comparisons. Their respective speeds after various periods of aging are shown in Table 4:-

Table 4

| Coating | Age (days) | Speed |
|---|---|---|
| Control Formulation 3 | 6 | 6.0 |
| | 15 | 4.8 |
| | 23 | 5.6 |
| | 34 | 16.9 |
| | 49 | 15.9 |
| Control Formulation 4 | 2 | 4.5 |
| | 15 | 4.5 |
| | 30 | 12.5 |
| | 40 | 11.2 |
| | 49 | >18.0 |

Both coatings showed wide variations in speed, with a marked speed loss after approximately three weeks storage. No advantage was apparent for the coating containing the sulphonamide, in the absence of an acid-cleavable compound.

## Claims

1. A positive-acting photoresist comprising in one or more layers
(i) a resin binder,
(ii) a photo-acid generator, and
(iii) an acid-cleavable compound, characterised in that the photoresist medium further comprises as a speed stabilising agent one or more compounds having a nucleus of general formula (I):

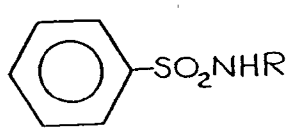

in which;
R represents a hydrogen atom or an optionally substituted alkyl group comprising up to 10 carbon atoms.

2. A positive-acting photoresist as claimed in Claim 1 in which R represents a substituted alkyl group possessing one or more substituents selected from hydroxy, nitro groups, halogen atoms, alkoxy groups comprising up to 5 carbon atoms and ester groups comprising up to 5 carbon atoms and the phenyl ring of the speed stabilising agent possesses one or more substituents selected from nitro groups, halogen atoms and alkyl groups comprising up to 10 carbon atoms.

3. A positive-acting photoresist as claimed in Claims 1 or 2 in which the speed stabilising agent is selected from benzene sulphonamide, N-ethyl-p-toluene sulphonamide, N-ethyl-o-toluene sulphonamide, N-butyl-p-toluene sulphonamide, o-tolune sulphonamide , p-toluene sulphonamide and mixtures thereof.

4. A positive-acting photoresist as claimed in any preceding Claim in which the compound(s) of general formula (I) comprise up to 25% by weight of the total solids content of the photosensitive medium.

5. A positive-acting photoresist as claimed in any preceding Claim in which the resin binder is selected from resoles, novolacs and mixture thereof, a hydroxystyrene copolymer or a derivative thereof.

6. A positive-acting photoresist as claimed in any preceding Claim in which the photo-acid generator comprises from 0.1 to 20.0 % by weight of the photosensitive medium and is selected from sulphonium salts, iodonium salts, phosphonium salts, diazonium salts, quinone diazide sulfochlorides, bis(trichloromethyl)-s-triazines, trichloromethylpyrones, mixtures of organometals and organohalogen compounds and combinations thereof.

7. A positive-acting photoresist as claimed in Claim 6 in which the photo-acid generator is an iodonium salt of general formula (II):

(II) 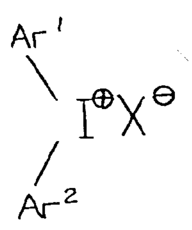

in which;
$Ar^1$ and $Ar^2$ independently represent aromatic or hetero-aromatic groups comprising up to 10 ring atoms which may be linked together to include the iodine atom within a ring structure, and

$X^{\ominus}$ is an anion such that HX is an acid of pka not greater than 3.

8. A positive-acting photoresist as claimed in any preceding Claim in which the acid-cleavable compound

comprises from 5 to 30% by weight and is selected from adducts of vinyl ethers with phenols or sulphonamides, polyacetals, polyketals, enol ethers, N-acyliminocarbonates, polymeric orthoesters, t-alkyl esters and carbonates, cyclic acetals and ketals of beta-ketocarbonyl compounds, silyl ether compounds, silyl ureido compounds and pyranyl or furanyl ethers of a bisphenol.

**9.** A positive-acting photoresist as claimed in Claim 8 in which the acid-cleavable compound has a nucleus of general formula (III):

(III) 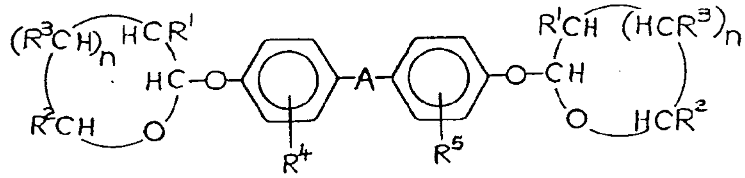

in which;

n is 0, 1, 2 or 3,

each $R^1$, $R^2$ and $R^3$ independently represents a hydrogen atom or an alkyl group comprising up to 4 carbon atoms,

$R^4$ and $R^5$ independently represent a hydrogen atom or one or more ring substituents selected from halogen atoms, alkyl groups comprising up to 4 carbon atoms, alkoxy groups comprising up to 4 carbon atoms and combinations thereof, and

A represents a bond or a divalent linking group comprising up to 10 atoms other than hydrogen.

**10.** A positive-acting photoresist as claimed in Claim 9 in which the compound of general formula (III) has a nucleus of one of the following structures:

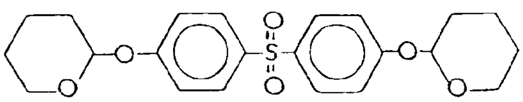

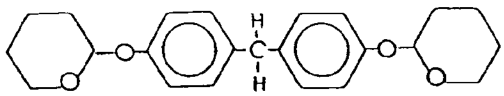

and,

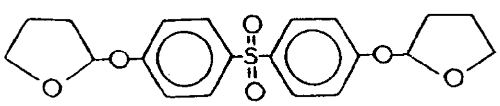

**11.** A photoresist as claimed in any preceding Claim further comprising up to 15% by weight of a sensitiser.

European Patent Office

# EUROPEAN SEARCH REPORT

Application Number

EP 92 30 2146

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,X | FR-A-2 325 076 (INTERNATIONAL BUSINESS MACHINES CORPORATION)<br>* page 2, line 21 - page 3, line 16; claims 1,4 * | 1-3 | G03F7/004<br>G03F7/022 |
| A<br>A | EP-A-0 330 239 (FUJI PHOTO FILM CO LTD)<br>* page 2, paragraph 40 - page 3, line 50; claims * | 1<br>1 | |
| A | EP-A-0 146 411 (MINNESOTA MINING AND MANUFACTURING COMPANY)<br>* the whole document * | 1-11 | |
| P,A | EP-A-0 424 124 (MINNESOTA MINING AND MANUFACTURING COMPANY)<br>* the whole document * | 1-11 | |
| | | | TECHNICAL FIELDS SEARCHED (Int. Cl.5) |
| | | | G03F |

The present search report has been drawn up for all claims

| Place of search | Date of completion of the search | Examiner |
|---|---|---|
| THE HAGUE | 07 JULY 1992 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)